(19) **Europäisches Patentamt European Patent Office Office européen des brevets**

(11) **EP 4 546 394 B1**

(12) **EUROPEAN PATENT SPECIFICATION**

(45) Date of publication and mention
of the grant of the patent:
**11.03.2026 Bulletin 2026/11**

(21) Application number: **23206066.5**

(22) Date of filing: **26.10.2023**

(51) International Patent Classification (IPC):
*H01J 37/244* (2006.01)   *H01J 37/28* (2006.01)
*H01J 37/02* (2006.01)

(52) Cooperative Patent Classification (CPC):
**H01J 37/244; H01J 37/023; H01J 37/28;**
H01J 2237/05; H01J 2237/24455; H01J 2237/2446;
H01J 2237/24465; H01J 2237/2802

(54) **ELECTRON MICROSCOPY DETECTOR**

ELEKTRONENMIKROSKOPIEDETEKTOR

DÉTECTEUR DE MICROSCOPIE ÉLECTRONIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**30.04.2025 Bulletin 2025/18**

(73) Proprietor: **The Provost, Fellows, Scholars and
other Members
Of the Board of Trinity College Dublin
D02 PN40 Dublin (IE)**

(72) Inventors:
• **JONES, Lewys
Dublin, D02 PN40 (IE)**

• **PETERS, Jonathan
Dublin, D02 PN40 (IE)**

(74) Representative: **Vienne, Aymeric Charles Emile et
al
Mathys & Squire
The Shard
32 London Bridge Street
London SE1 9SG (GB)**

(56) References cited:
**EP-A1- 2 696 363     EP-A1- 3 534 391
EP-A1- 3 637 452     EP-A1- 3 965 137
US-A1- 2008 315 094**

# Description

## Field of Invention

The invention relates but is not limited to imaging devices for a scanning transmission electron microscope. The invention also relates to corresponding method for operating such an imaging devices.

## Background of Invention

In a conventional scanning transmission electron microscope (STEM), a focussed beam of electrons is scanned across a sample under inspection. A conventional STEM may comprise a pixelated detection unit (for example, a unit of 128x128 pixels, 192x192 pixels, or of 264x264 pixels). The detection unit is conventionally configured to receive the electrons after they have been transmitted through the sample under inspection.

Such conventional STEMs comprising such a pixelated detection unit have two main drawbacks.

The first drawback is the very high data-rate needed to support a readout of the pixelated detection unit (up to 200 TB.hr$^{-1}$).

The second drawback is that the majority of pixelated detection units do not allow, in practice, an electron energy-loss spectroscopy (EELS) of good quality, as most do not incoporate a central hole. Some pixelated detection units comprise a hole at their centre to allow a central portion of the electron beam to pass and be used for electron energy-loss spectroscopy (EELS). However, in these cases, a significant amount of electrons are lost in a dead layer surrounding the central hole and are not available for the EELS.

EP-A1-3534391 discloses a discriminative imaging technique in scanning transmission charged particle microscopy. EP-A1-3637452 discloses a charged particle microscope. EP-A1-3965137 discloses a system and method for simultaneous phase contrast imaging and electron energy-loss spectroscopy. EP-A 1-2696363 discloses an electron microscope. US-A1-2008/315094 discloses charged particle detection devices.

## Summary of Invention

The invention is defined by the appended claims. These and other aspects, and embodiments which are helpful in understanding the invention are set out in the following.

## Brief description of the Drawings

Aspects of the disclosure will now be described, by way of example, with reference to the accompanying drawings in which:

Figure 1A and Figure 1B schematically show a cross section of an imaging device for a scanning transmission electron microscope;
Figures 2A, 2B and 2C schematically show a top view of means for mutually displacing the plurality of detector modules between a plurality of configurations;
Figures 3A and 3B schematically show a top view of a detection unit comprising two pixelated detector modules;
Figures 4A, 4B and 4C schematically show a top view of a detection unit comprising four pixelated detector modules;
Figure 5 schematically shows a top view of a detector module comprising means for a readout of the pixels of the module;
Figures 6 and 7 show an electric schematic of means for a readout of the detectors;
In Figure 8 schematically shows a cross section of a pixel of a pixelated detector module;
Figure 9 schematically shows means for mutually displacing the plurality of detector modules;
Figure 10 schematically shows general steps of a method of operating a detection unit.

In the figures, similar elements bear the same numerical reference.

## Detailed description

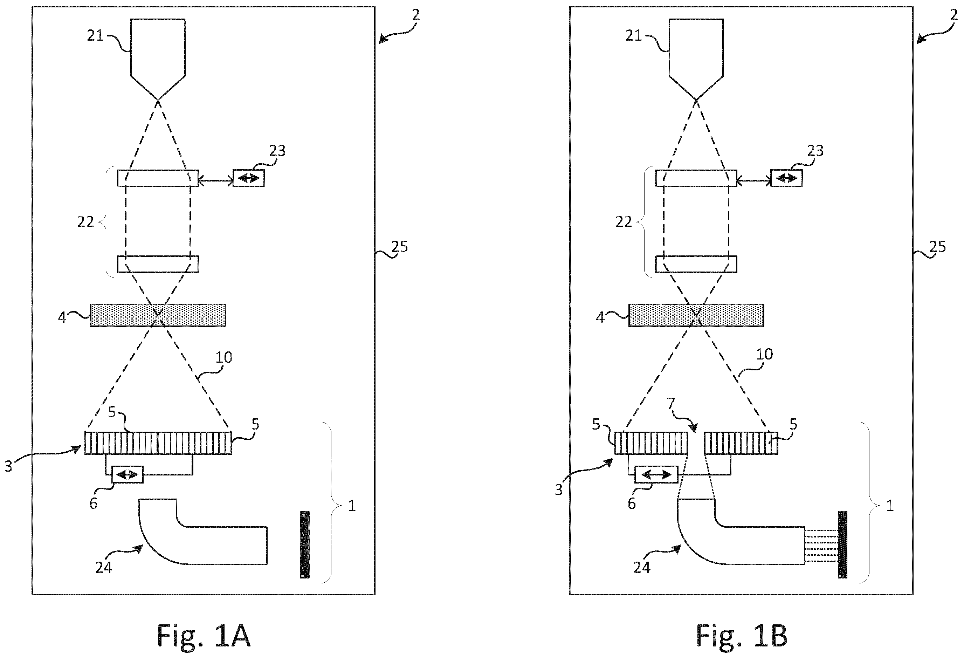

Figure 1A and Figure 1B schematically show an imaging device 1 for a scanning transmission electron microscope 2.

In Figures 1A and 1B, the imaging device 1 comprises a detection unit 3. The detection unit 3 is configured to receive electrons 10 after they have been transmitted through a sample 4 under inspection.

In Figures 1A and 1B, the detection unit 3 comprises a plurality of pixelated detector modules 5.

In Figures 1A and 1B, the detection unit 3 further comprises means 6 for mutually displacing the plurality of detector modules 5 between at least two configurations.

A first configuration of the plurality of detector modules 5 is represented in Figure 1A. In

Figure 1A, the plurality of detector modules 5 are adjacent to each other such that there is no hole in the detection unit 3.

A second configuration of the plurality of detector modules 5 is represented in Figure 1B. In Figure 1B, the plurality of detector modules 5 are mutually displaced with respect to each other such that there is a hole 7 in the detection unit 3.

The imaging device of the disclosure is thus a hybrid device and comprises a full configuration and/or a holed configuration.

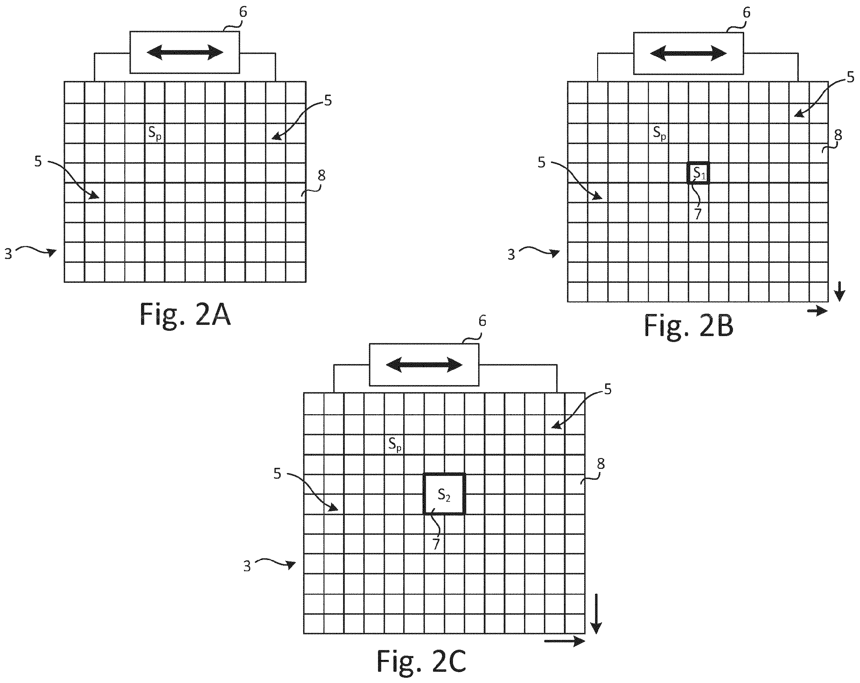

Figures 2A, 2B and 2C schematically show means 6 for mutually displacing a plurality of detector modules 5, which are further configured to mutually displace the detector modules 5 between at least two configurations and one additional configuration.

Figures 2A and 2B schematically show that the means 6 for mutually displacing the plurality of detector modules 5 are configured to mutually displace the detector modules 5 from a first configuration (Figure 2A) to a second configuration (Figure 2B) or vice versa.

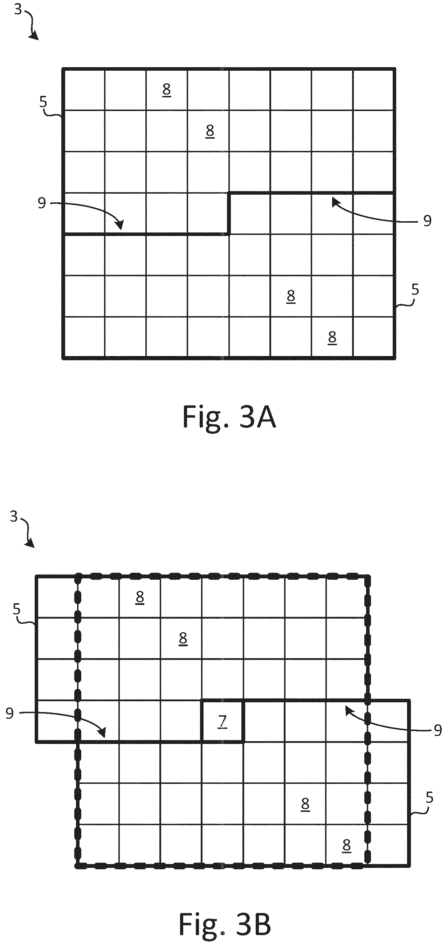

In Figure 2B, a hole 7 has a first desired area $S_1$. In the second configuration, the detection unit 3 occupies a larger total area than in the first configuration, due to the displacement of detector modules 5 (indicated schematically by arrows) to provide a hole 7. Examples of how the detection modules 5 may be displaced are described below with reference to Figures 3A-4C.

Figures 2B and 2C schematically show that the means 6 for mutually displacing the plurality of detector modules 5 are configured to mutually displace the detector modules 5 from the second configuration (Figure 2B) to a third configuration (Figure 2C) or vice versa, or between the third configuration (Figure 2C) and the first configuration (Figure 2A). In

Figure 2C, the hole 7 has a second desired area $S_2$, the second desired area $S_2$ being different from the first desired area $S_1$. In the third configuration, the detection unit 3 occupies a larger total area than in the first configuration, due to the displacement of detector modules 5 (indicated schematically by arrows) to provide a hole 7. In this example, in the third configuration the detection unit 3 also occupies a larger total area than in the second configuration.

Figures 2B and 2C schematically show that the first desired area $S_1$ (area equivalent to 1 area $S_p$ of a pixel 8) and the second desired area $S_2$ (area equivalent to 4 areas $S_p$ of a pixel 8) are such that:

$$\tfrac{1}{4}.S_p \leq S_1 \leq S_2 \leq 9.S_p$$

wherein $S_p$ is the area of a pixel of the pixelated detector modules.

Figures 3A and 3B schematically show a detection unit 3 comprising two pixelated detector modules 5. In Figures 3A and 3B, each one of the two pixelated detector modules 5 comprises a gridded array of detectors configured to form pixels 8 of the module 5. In Figures 3A and 3B, each gridded array is indented on one edge 9 such that the one edge 9 of the gridded array is configured to linearly slidably cooperate with another corresponding edge 9 of the other pixelated detector module 5 of the two pixelated detector modules, in order to open (Figure 3B) and close (Figure 3A) a hole 7 in the detection unit 3. In Figures 3A and 3B, each pixelated detector module 5 has a height of four lines of pixels 8, with three lines having eight pixels 8 and with the edge 9 having four pixels 8 to form the indent. In Figure 3A, the closed detection unit 3 is an array of 7x8 pixels. In Figure 3B, the detection unit 3 has the 1x1 hole 7 and a retained square (shown by the dotted line) of 7x7 pixels. The embodiment of Figures 3A and 3B enables accurate Centre of Mass (COM) imaging and EELS (Figure 3B).

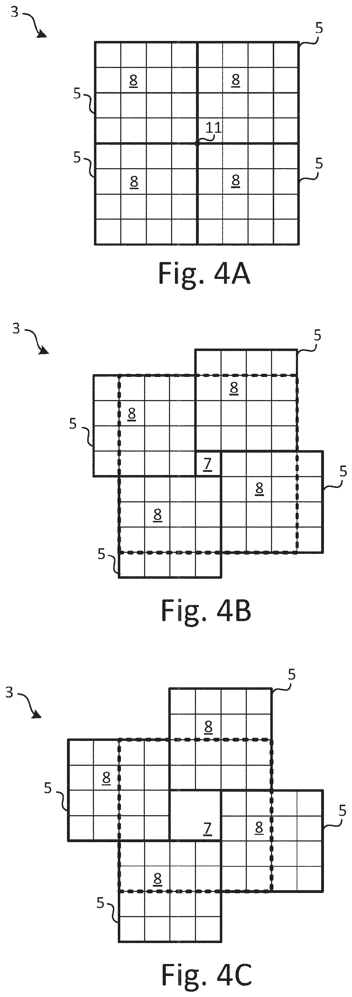

Figures 4A, 4B and 4C schematically show a detection unit 3 comprising four pixelated detector modules 5. In Figures 4A and 4B, each one of the four pixelated detector modules 5 comprises a gridded array of detectors configured to form pixels 8 of the module 5. In Figures 4A, 4B and 4C, the four detector modules 5 are configured to cooperate with each other such that in a first configuration (Figure 4A), the four detector modules are adjacent to each other and abut at one point 11, and in a second configuration (Figures 4B and 4C), the four detector modules 5 are mutually displaced with respect to each other such that a hole 7 is located at a centre of the detection unit 3, as shown by the dotted lines in Figure 4B and Figure 4C. In Figure 4B, the hole 7 has a first area and the detection unit 3 has a 7x7 pixels square area. In Figure 4C, the hole 7 has a second area, greater than the first area of Figure 4B, and the detection unit 3 has a 6x6 pixel square area. In Figure 4A, the point 11 is also forming the centre of the detection unit 3, the detection unit 3 having a 8x8 square area.

In Figures 4A, 4B and 4C, each module 5 is a square matrix of detectors, each module having the same number of pixels 8 as the other modules 5 in the detector unit 3. In Figures 4A, 4B and 4C, each module is a 4x4 matrix. Other sizes are envisaged, such as an 8x8 matrix.

In Figures 4A, 4B and 4C, each pixelated detector module 5 is mounted at a corner of a conforming printed circuit board (not shown in Figures 4A, 4B and 4C), for two-side tileable cooperation with other detector modules 5 of the detection unit 3. In Figures 4A, 4B and 4C, the detection unit 3 has thus a 4-fold symmetry at all times, and the embodiment of Figures 4A, 4B and 4C enables accurate COM imaging, EELS (Figures 4B and 4C) and differential phase contrast (DPC) imaging.

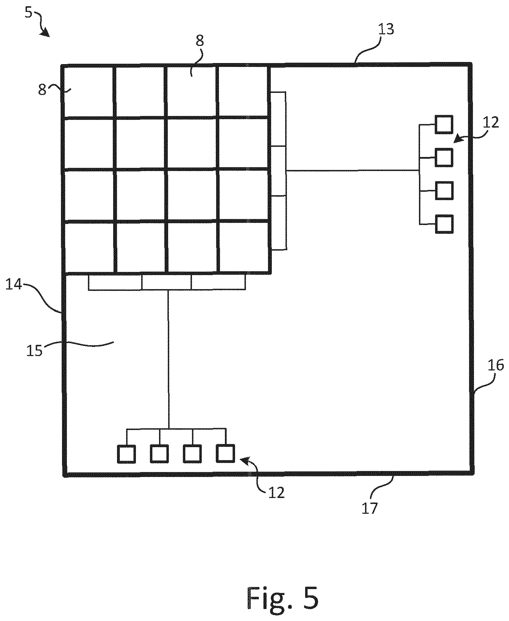

In Figure 5, a pixelated detector module 5 further comprises means 12 for a readout of pixels 8 of the module 5. The means 12 for the readout may comprise amplifiers. In Figure 5, the pixelated detector module 5 is mounted along a portion of each of two edges 13 and 14 of a conforming printed circuit board 15. In Figure 5, the means 12 for the readout are located along two other edges 16 and 17 of the detector module 5, on the printed circuit board 15. However, the means could be placed at another location, for example on another face of the printed circuit board compared to the detector module.

In some examples, the means for the readout are configured to read the detectors individually. In such an example, for a 4x4 module, the number of readouts is 16.

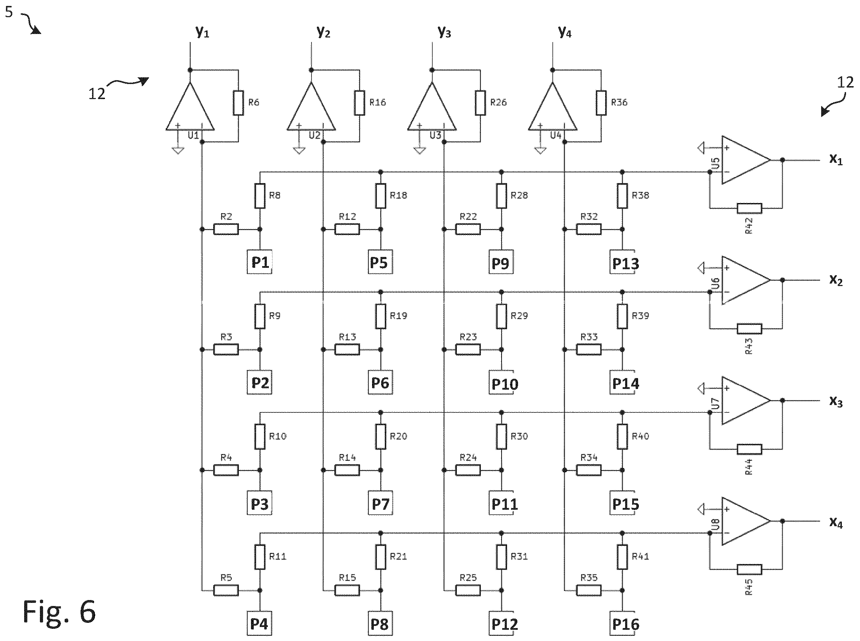

In Figure 6, the means 12 for the readout are configured to read the detectors as whole columns and rows. In this example circuit, detector signals for the pixels 8 of a 4x4 module are represented by nodes P1 to P16, and for each row and column of pixels, the nodes corresponding to the given row or column or pixels are electrically coupled in parallel to provide a single readout signal for the whole row/column (e.g. via an amplifier electrically coupled in parallel to the row/column nodes). For example, the nodes P1, P5, P9 and P13 corresponding to a row of pixels are connected in parallel so as to produce a readout signal $x_1$ for that row, and the nodes P1 to P4 corresponding to a column of pixels are also connected in parallel so as to produce a readout signal $y_1$ for that column. Accordingly, if a detector detects an event (e.g. an incident electron) and produces an output signal, corresponding x- and y-readouts will be affected. In Figure 6, the location of an event (i.e., an incident electron) detected on the module 5 is then retrieved as a logical 'AND' of the readouts of a column and a row. For example, if the readouts $x_1$ and $y_1$ both take a non-zero value or change their value, this indicates that the pixel detector corresponding to node P1 has detected an event. In Figure 6, the number of readouts is 8, which may reduce the size of the module 5 and the overall detection unit. The detection unit may further comprise high-speed analog-to-digital converters configured to convert the analog signals from the detector nodes to digital (e.g. binary or quantised) signals. Reducing the number of readouts also reduces the number of high-speed analog-to-digital converters used in the detection unit.

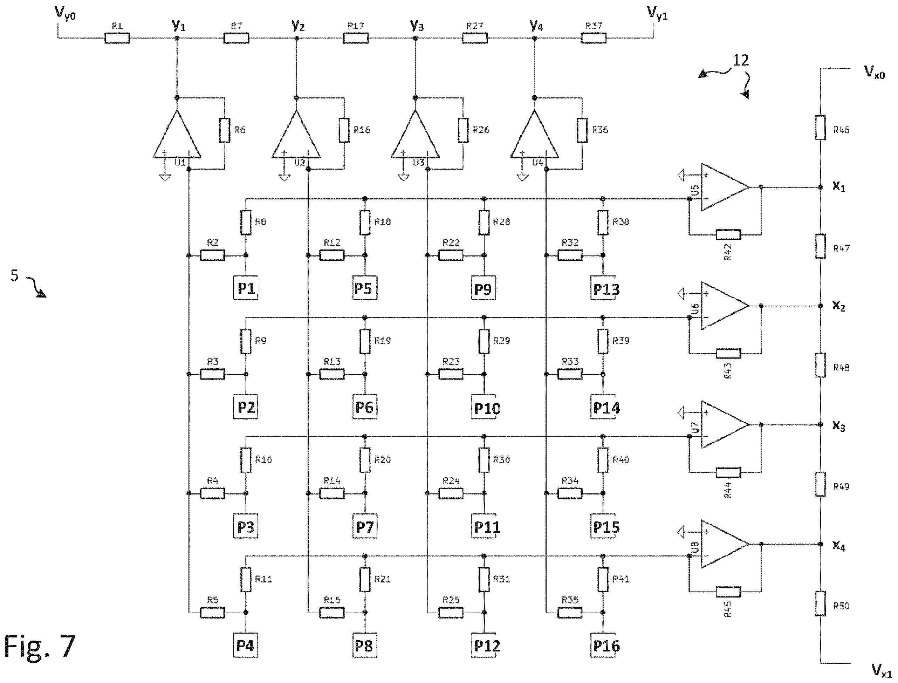

In Figure 7, the means 12 for the readout are configured to read the detectors as whole columns and rows by feeding signal chains of the column readings and the row readings into respective resistor ladders. In the example shown in Figure 7, the readout signals $x_1$ to $x_4$ for detecting events in the rows of the detector are connected to a row resistor ladder having output voltages $V_{x0}$ and $V_{x1}$ at its extremities. Similarly, the readout signals $y_1$ to $y_4$ for detecting events in the columns of the detector are connected to a column resistor ladder having output voltages $V_{y0}$ and $V_{y1}$ at its extremities. In Figure 7 the location of a detected event is retrieved by reading out both extremities of each resistor ladder. In particular, the resistor ladder enables the readout of each resistor ladder (determined by calculating the difference between the extremity voltages) to take a unique value for each combination of row/column signals. For example, by virtue of the ladder arrangement of resistors, the row resistor ladder output (determined as $V_{x1} - V_{x0}$) has a different value for each combination of row readout signals $x_1$ to $x_4$. The same principle applies to the column resistor ladder output ($V_{y1} - V_{y0}$). Therefore, in Figure 7, the number of readouts is 4 per module, which may further reduce the size of the module 5 and the overall detection unit, and also further reduces the number of high-speed analog-to-digital converters used in the detection unit.

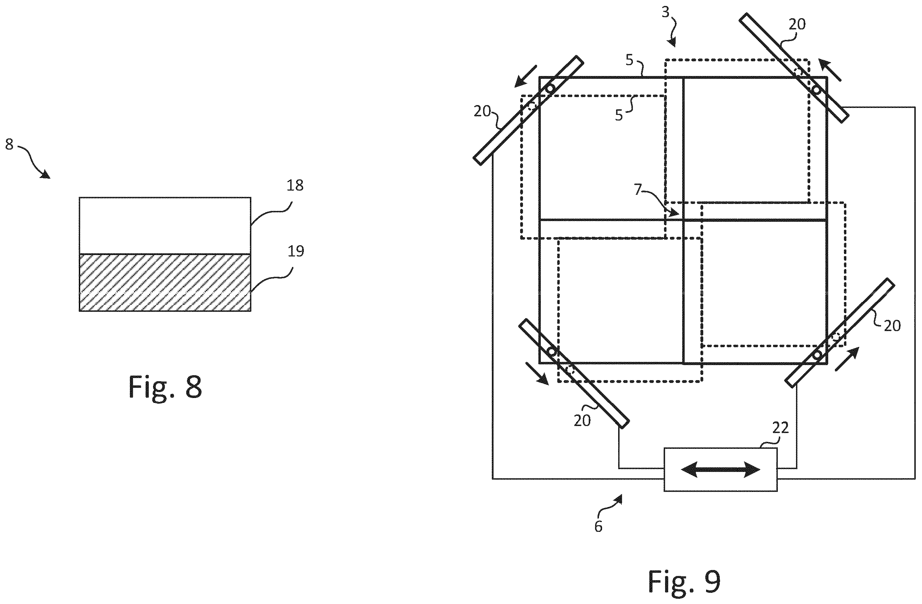

In Figure 8, each pixel 8 of the pixelated detector modules comprises a scintillator 18 (such as a YAG scintillator, but other types are envisaged) configured to convert incident electrons into light pulses, the scintillator 18 being mounted on an avalanche photodiode 19. The scintillator 18 is a man-made single-crystal, and the sensitive area can reach right to the edges 13 and 14 of the module 5 as shown in Figure 5, leading to zero dead-layer around each pixel 8 or around a hole in the detection unit. As a result, all electrons across the detection plane would either be detected by one of the detector pixels 8 or be available to the EELS spectrometer. This eliminates any dead-layer and provides for more efficient overall information collection. This arrangement also enables readout speeds compliant with scanning transmission electron microscopy.

Due to this arrangement, each pixel of the pixelated detector modules 5 may have a side length x such that:

$$1mm \leq x \leq 6mm.$$

Other dimensions are envisaged. However, thanks to the relatively large side length x of each pixel of the detector modules, the imaging device of the disclosure enables the use of a detection unit comprising fewer than 256 pixels, e.g., with modules which are each smaller than, or equal to, an 8x8 matrix. The readout of the detection unit of the disclosure has a relatively low data-rate with satisfactory performances, and e.g., the peak signal to noise ratio (PSNR) of a ptychographic phase reconstruction using the detection unit of the disclosure may be as satisfactory as that of a conventional detection unit of e.g., 1024 pixels.

Figure 9 schematically shows that the means 6 for mutually displacing the plurality of detector modules 5 comprise an actuator 20 configured to move the detector modules 5 cooperatively with respect to each other, such as along a linear or non-linear movement. In Figure 9, the displacing means 6 comprises a plurality of actuators 20 (e.g. one actuator per detector module) each configured to displace a detector module 5 linearly (e.g. in a direction oriented at 45° to the pixel arrays, as indicated by the arrows). For example, the actuator 20 may attach to a location on the module 5 that is distant from the hole 7 formed when displacing the modules 5, such that the displacing means 6 does not interfere with detection of electrons through the hole. The actuators 20 may be communicably coupled to a controller 22 configured to control the actuators simultaneously. The controller 22 may also be used to receive data from each actuator for feedback control of the detection unit, the data indicative of the position of the detector modules.

In other examples, a single actuator 20 may be configured to configured to displace multiple (e.g. all) of the modules 5. For example, the detector modules 5 may be connected by a linkage mechanism that can be driven (linearly or otherwise) with a single actuator such that the modules 5 are displaced in their respective directions indicated by the arrows in Figure 9. Alternatively or additionally, the movement of all four modules may be synchronised with a single slotted wheel driven by a single actuator.

Referring back to Figures 1A and 1B, the imaging device 1 may further comprise:

a source 21 of the electrons 10;
means 22 for focussing the electrons 10 into a beam to irradiate the sample 4 under inspection;
means 23 for scanning the beam on the sample 4;
a spectral analysis unit 24 located below the detection unit 3, and
a vacuum chamber 25 enclosing the source 21, the means 22 and 23 for focussing and scanning, the sample 4 when present, the detection unit 3, the means 6 for mutually displacing the plurality of detector modules 5 of the detection unit 3, and the spectral analysis unit 24.

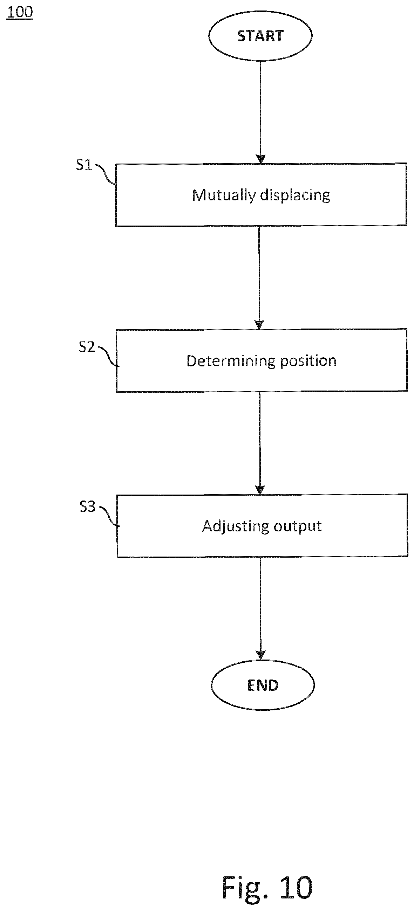

Figure 10 schematically shows a method 100 of operating a detection unit of an imaging device for a scanning transmission electron microscope.

In Figure 10, the method 100 comprises mutually displacing, at S1, a plurality of detector modules of the detection unit to control an area of a hole in the detection unit.

The detection unit may be a detection unit of any aspects of the disclosure.

In Figure 10, the method 100 further comprises:

determining, at S2, a position of the plurality of pixelated detector modules after their mutual displacement performed at S1; and
adjusting, at S3, an output data-stream from the detection unit, based on the determined position.

This enables accurate reading of events detected on the detection unit.

**Claims**

1. An imaging device (1) for a scanning transmission electron microscope, comprising:

   a detection unit (3) comprising a plurality of pixelated detector modules (5), the detection unit being configured to receive electrons after they have been transmitted through a sample under inspection; and
   means (6) for mutually displacing the plurality of detector modules between at least two configurations:

   a first configuration where the plurality of detector modules are adjacent to each other such that there is no hole in the detection unit, and
   a second configuration where the plurality of detector modules are mutually displaced with respect to each other such that there is a hole (7) in the detection unit (3).

2. The imaging device (1) of claim 1, wherein the means (6) for mutually displacing the plurality of detector modules (5) are further configured to mutually displace the detector modules from the first configuration to the second configuration, such that in the second configuration the hole has a first desired area, optionally wherein the means for mutually displacing the plurality of detector modules are further configured to mutually displace the detector modules between a third configuration and the first configuration and/or the second configuration, the hole having, in the third configuration, a second desired area that is different from the first desired area.

3. The imaging device (1) of claim 1 or 2, wherein the first and/or second desired areas S are such that:

$$\tfrac{1}{4}.Sp \leq S \leq 9.Sp$$

wherein Sp is the area of a pixel (8) of the pixelated detector modules (5).

4. The imaging device (1) of any preceding claim, wherein the detection unit (3) comprises two pixelated detector modules (5),
each one of the two pixelated detector modules comprising a gridded array of detectors configured to form the pixels (8) of the module, the gridded array being indented on one edge (9) such that the one edge of the array is configured to linearly slidably cooperate with another corresponding edge of the other pixelated detector module of the two pixelated detector modules, in order to open and close the hole in the detection unit.

5. The imaging device (1) of any of claims 1 to 3, wherein the detection unit (3) comprises four pixelated detector modules (5), each one of the four pixelated detector modules comprising a gridded array of detectors configured to form the pixels (8) of the module, the four detector modules being configured to cooperate with each other such that:

   in the first configuration, the four detector modules are adjacent to each other and abut at one point (11),
   in the second configuration, the four detector modules are mutually displaced with respect to each other such that the hole (7) is located at the centre of the detection unit.

6. The imaging device (1) of claim 5, wherein each module (5) is a square matrix of detectors, each module having the same number of pixels (8) as the other modules in the detector unit (3), optionally wherein each module is a 4x4 or an 8x8 matrix.

7. The imaging device (1) of claim 5 or 6, wherein each pixelated detector module (5) is mounted at a corner of a conforming printed circuit board (15), for two-side tileable cooperation with other detector modules of the detection unit (3).

8. The imaging device (1) of claim 7, wherein each pixelated detector module (5) further comprises means (12) for a readout of the pixels (8) of the module, optionally wherein each pixelated detector module is mounted along a portion of each of two edges of the conforming printed circuit board and wherein the means for the readout are located along two other edges of the detector module, on the printed circuit board.

9. The imaging device (1) of claim 8, wherein the means (12) for the readout are configured to read the detectors either individually or as whole columns and rows, and wherein the location of an event detected on the module (5) is then retrieved as a logical 'AND' of the readouts of a column and a row, or wherein the means for the readout are configured to read the detectors as whole columns and rows by feeding signal chains of the column readings and the row readings into respective resistor ladders, and wherein the location of a detected event is retrieved by reading out both extremities of each resistor ladder.

10. The imaging device (1) of any of the preceding claims, wherein each pixel (8) of the pixelated detector modules (5) comprises a scintillator configured to convert incident electrons into light pulses, the scintillator being mounted on an avalanche photodiode.

11. The imaging device (1) of any of the preceding claims, wherein each pixel (8) of the pixelated detector modules (5) has a side length x such that:

$$1mm \leq x \leq 6mm.$$

12. The imaging device (1) of any of the preceding claims, wherein the means (6) for mutually displacing the plurality of detector modules (5) comprise an actuator configured to move the detector modules cooperatively with respect to each other, such as along a linear or non-linear movement.

13. The imaging device (1) of any of the preceding claims, further comprising:

a source (21) of the electrons;
means (22) for focussing the electrons into a beam to irradiate the sample under inspection;
means (23) for scanning the beam on the sample;

a spectral analysis unit (24) located below the detection unit (3), and
a vacuum chamber (25) enclosing the source, the means for focussing and scanning, the sample when present, the detection unit, the means (6) for mutually displacing the plurality of detector modules (5) of the detection unit, and the spectral analysis unit.

14. A method (100) for operating an imaging device (1) for a scanning transmission electron microscope, the imaging device comprising a detection unit (3) comprising a plurality of pixelated detector modules (5), the detection unit being configured to receive electrons after they have been transmitted through a sample to inspect, the method comprising mutually displacing the plurality of detector modules to control an area of a hole (7) in the detection unit.

15. The method (100) of claim 14, further comprising:

determining a position of the plurality of pixelated detector modules (5) after their mutual displacement; and
adjusting an output data-stream from the detection unit (3), based on the determined position.

**Patentansprüche**

1. Bildgebungsvorrichtung (1) für ein Rastertransmissionselektronenmikroskop, die Folgendes umfasst:

eine Detektionseinheit (3) mit mehreren pixelierten Detektormodulen (5), wobei die Detektionseinheit zum Empfangen von Elektronen nach deren Durchtritt durch eine zu prüfende Probe konfiguriert ist; und
Mittel (6) zum gegenseitigen Verschieben der mehreren Detektormodule zwischen mindestens zwei Konfigurationen:

einer ersten Konfiguration, in der die mehreren Detektormodule so nebeneinander angeordnet sind, dass in der Detektionseinheit kein Loch vorhanden ist, und
einer zweiten Konfiguration, in der die mehreren Detektormodule so gegeneinander verschoben sind, dass in der Detektionseinheit (3) ein Loch (7) vorhanden ist.

2. Bildgebungsvorrichtung (1) nach Anspruch 1, wobei das Mittel (6) zum gegenseitigen Verschieben der mehreren Detektormodule (5) ferner zum gegenseitigen Verschieben der Detektormodule von der ersten Konfiguration in die zweite Konfiguration konfiguriert sind, so dass in der zweiten Konfiguration das Loch eine erste gewünschte Fläche aufweist, wobei optional das Mittel zum gegenseitigen Verschieben der mehreren Detektormodule ferner so konfiguriert sind, dass sie die Detektormodule zwischen einer dritten Konfiguration und der ersten Konfiguration und/oder der zweiten Konfiguration gegenseitig verschieben, wobei das Loch in der dritten Konfiguration eine zweite gewünschte Fläche aufweist, die sich von der ersten gewünschten Fläche unterscheidet.

3. Bildgebungsvorrichtung (1) nach Anspruch 1 oder 2, wobei die erste und/oder zweite gewünschte Fläche S so sind, dass:

$$\tfrac{1}{4}.Sp \leq S \leq 9.Sp$$

wobei Sp die Fläche eines Pixels (8) der pixelierten Detektormodule (5) ist.

4. Bildgebungsvorrichtung (1) nach einem vorherigen Anspruch, wobei die Detektionseinheit (3) zwei pixelierte Detektormodule (5) umfasst, wobei jedes der beiden pixelierten Detektormodule ein gerastertes Array von Detektoren umfasst, die zum Bilden der Pixel (8) des Moduls konfiguriert sind, wobei das gerasterte Array an einer Kante (9) so eingebuchtet ist, dass die eine Kante des Array zum linear verschiebbaren Zusammenwirken mit einer anderen entsprechenden Kante des anderen pixelierten Detektormoduls der beiden pixelierten Detektormodule konfiguriert ist, um das Loch in der Detektionseinheit zu öffnen und zu schließen.

5. Bildgebungsvorrichtung (1) nach einem der Ansprüche 1 bis 3, wobei die Detektionseinheit (3) vier pixelierte Detektormodule (5) umfasst, wobei jedes der vier pixelierten Detektormodule ein gerastertes Array von Detektoren umfasst, die zum Bilden der Pixel (8) des Moduls konfiguriert sind, wobei die vier Detektormodule zum Zusammenwirken miteinander konfiguriert sind, so dass:

in der ersten Konfiguration die vier Detektormodule nebeneinander liegen und an einem Punkt (11) aneinanderstoßen,
in der zweiten Konfiguration die vier Detektormodule in Bezug zueinander so verschoben sind, dass sich das Loch (7) in der Mitte der Detektionseinheit befindet.

6. Bildgebungsvorrichtung (1) nach Anspruch 5, wobei jedes Modul (5) eine quadratische Matrix von Detektoren ist, wobei jedes Modul dieselbe Anzahl von Pixeln (8) wie die anderen Module in der Detektoreinheit (3) aufweist, wobei optional jedes Modul eine 4x4- oder eine 8x8-Matrix ist.

7. Bildgebungsvorrichtung (1) nach Anspruch 5 oder 6, wobei jedes pixelierte Detektormodul (5) an einer Ecke einer konformen Leiterplatte (15) für ein beidseitiges kachelbares Zusammenwirken mit anderen Detektormodulen der Detektionseinheit (3) montiert ist.

8. Bildgebungsvorrichtung (1) nach Anspruch 7, wobei jedes pixelierte Detektormodul (5) ferner Mittel (12) zum Auslesen der Pixel (8) des Moduls umfasst, wobei optional jedes pixelierte Detektormodul entlang eines Abschnitts jeder der beiden Kanten der konformen Leiterplatte montiert ist, und wobei sich die Mittel zum Auslesen entlang zweier anderer Kanten des Detektormoduls auf der Leiterplatte befinden.

9. Bildgebungsvorrichtung (1) nach Anspruch 8, wobei das Auslesemittel (12) zum Auslesen der Detektoren entweder einzeln oder als ganze Spalten und Zeilen konfiguriert ist, und wobei die Position eines auf dem Modul (5) erkannten Ereignisses dann als logisches "UND" der Auslesungen einer Spalte und einer Zeile abgerufen wird, oder wobei das Auslesemittel zum Auslesen der Detektoren als ganze Spalten und Zeilen durch Einspeisen von Signalketten der Spaltenauslesungen und der Zeilenauslesungen in jeweilige Widerstandsleitern konfiguriert ist, und wobei die Position eines erkannten Ereignisses durch Auslesen beider Enden jeder Widerstandsleiter abgerufen wird.

10. Bildgebungsvorrichtung (1) nach einem der vorherigen Ansprüche, wobei jedes Pixel (8) der pixelierten Detektormodule (5) einen Szintillator umfasst, der zum Umwandeln einfallender Elektronen in Lichtimpulse konfiguriert ist, wobei der Szintillator auf einer Avalanche-Fotodiode montiert ist.

11. Bildgebungsvorrichtung (1) nach einem der vorherigen Ansprüche, wobei jedes Pixel (8) der pixelierten Detektormodule (5) eine Seitenlänge x aufweist, so dass:

$$1\ mm \leq x \leq 6\ mm.$$

12. Bildgebungsvorrichtung (1) nach einem der vorherigen Ansprüche, wobei das Mittel (6) zum gegenseitigen Verschieben der mehreren Detektormodule (5) einen Aktuator umfasst, der zum kooperativen Bewegen der Detektormodule in Bezug zueinander, beispielsweise entlang einer linearen oder nichtlinearen Bewegung, konfiguriert ist.

13. Bildgebungsvorrichtung (1) nach einem der vorherigen Ansprüche, die ferner Folgendes umfasst:

eine Quelle (21) für die Elektronen;

Mittel (22) zum Fokussieren der Elektronen zu einem Strahl, um die zu prüfende Probe zu bestrahlen;

Mittel (23) zum Abtasten des Strahls auf der Probe;

eine Spektralanalyseeinheit (24), die sich unterhalb der Detektionseinheit (3) befindet, und

eine Vakuumkammer (25), die die Quelle, das Mittel zum Fokussieren und Abtasten, die Probe, falls vorhanden, die Detektionseinheit, das Mittel (6) zum gegenseitigen Verschieben der mehreren Detektormodule (5) der Detektionseinheit und die Spektralanalyseeinheit einhaust.

14. Verfahren (100) zum Betreiben einer Bildgebungsvorrichtung (1) für ein Rastertransmissionselektronenmikroskop, wobei die Bildgebungsvorrichtung eine Detektionseinheit (3) mit mehreren pixelierten Detektormodulen (5) umfasst, wobei die Detektionseinheit zum Empfangen von Elektronen nach deren Durchtritt durch eine zu prüfende Probe konfiguriert ist, wobei das Verfahren das gegenseitige Verschieben der mehreren Detektormodule umfasst, um einen Bereich eines Lochs (7) in der Detektionseinheit zu steuern.

15. Verfahren (100) nach Anspruch 14, das ferner Folgendes umfasst:

Bestimmen einer Position der mehreren pixelierten Detektormodule (5) nach ihrer gegenseitigen Verschiebung; und

Justieren eines Ausgabedatenstroms aus der Detektionseinheit (3) auf der Basis der bestimmten Position.

## Revendications

1. Dispositif d'imagerie (1) pour un microscope électronique à transmission et à balayage, comprenant :

une unité de détection (3) comprenant une pluralité de modules de détection pixellisés (5), l'unité de détection étant configurée pour recevoir des électrons après qu'ils ont été transmis à travers un échantillon à inspecter ; et
des moyens (6) pour déplacer mutuellement la pluralité de modules de détection entre au moins deux configurations :

une première configuration dans laquelle la pluralité de modules de détection sont adjacents les uns aux autres de manière à ce qu'il n'y ait pas de trou dans l'unité de détection, et

une deuxième configuration dans laquelle la pluralité de modules de détection sont déplacés mutuellement les uns par rapport aux autres de manière à ce qu'il y ait un trou (7) dans l'unité de détection (3).

2. Dispositif d'imagerie (1) selon la revendication 1, dans lequel les moyens (6) pour déplacer mutuellement la pluralité de modules de détection (5) sont en outre configurés pour déplacer mutuellement les modules de détection de la première configuration à la deuxième configuration, de sorte que dans la deuxième configuration, le trou a une première surface souhaitée, éventuellement dans lequel les moyens pour déplacer mutuellement la pluralité de modules de détection sont en outre configurés pour déplacer mutuellement les modules de détection entre une troisième configuration et la première configuration et/ou la deuxième configuration, le trou ayant, dans la troisième configuration, une seconde surface souhaitée qui est différente de la première surface souhaitée.

3. Dispositif d'imagerie (1) selon la revendication 1 ou 2, dans lequel la première et/ou la seconde surface souhaitée S sont telles que :

$$\tfrac{1}{4}.Sp \leq S \leq 9.Sp$$

où Sp est la surface d'un pixel (8) des modules de détection pixellisés (5).

4. Dispositif d'imagerie (1) selon une quelconque revendication précédente, dans lequel l'unité de détection (3) comprend deux modules de détection pixellisés (5),
chacun des deux modules de détection pixellisés comprenant un réseau quadrillé de détecteurs configurés pour former les pixels (8) du module, le réseau quadrillé étant indenté sur un bord (9) de sorte que ledit bord du réseau est configuré pour coopérer par coulissement linéaire avec un autre bord correspondant de l'autre module de détection pixellisé des deux modules de détection pixellisés, afin d'ouvrir et de fermer le trou dans l'unité de détection.

5. Dispositif d'imagerie (1) selon l'une quelconque des revendications 1 à 3, dans lequel l'unité de détection (3) comprend quatre modules de détection pixellisés (5), chacun des quatre modules de détection pixellisés comprenant un réseau quadrillé de détecteurs configurés pour former les pixels (8) du module, les quatre modules de détection étant configurés pour coopérer les uns avec les autres de telle sorte que :

dans la première configuration, les quatre modules de détection sont adjacents les uns aux autres et viennent en butée en un point (11), dans la seconde configuration, les quatre modules de détection sont déplacés mutuellement les uns par rapport aux autres, de sorte que le trou (7) est situé au centre de l'unité de détection.

6.  Dispositif d'imagerie (1) selon la revendication 5, dans lequel chaque module (5) est une matrice carrée de détecteurs, chaque module ayant le même nombre de pixels (8) que les autres modules de l'unité de détection (3), éventuellement dans lequel chaque module est une matrice 4x4 ou 8x8.

7.  Dispositif d'imagerie (1) selon la revendication 5 ou 6, dans lequel chaque module de détection pixellisé (5) est monté dans un coin d'une carte de circuit imprimé conforme (15), pour une coopération tuilable sur deux côtés avec d'autres modules de détection de l'unité de détection (3).

8.  Dispositif d'imagerie (1) selon la revendication 7, dans lequel chaque module de détection pixellisé (5) comprend en outre des moyens (12) pour une lecture des pixels (8) du module, éventuellement dans lequel chaque module de détection pixellisé est monté le long d'une partie de chacun de deux bords de la carte de circuit imprimé conforme et dans lequel les moyens pour la lecture sont situés le long de deux autres bords du module de détection, sur la carte de circuit imprimé.

9.  Dispositif d'imagerie (1) selon la revendication 8, dans lequel les moyens (12) pour la lecture sont configurés pour lire les détecteurs soit individuellement, soit en tant que colonnes et lignes entières, et dans lequel l'emplacement d'un événement détecté sur le module (5) est ensuite récupéré en tant que « ET » logique des lectures d'une colonne et d'une ligne, ou
dans lequel les moyens pour la lecture sont configurés pour lire les détecteurs en tant que colonnes et lignes entières en introduisant des chaînes de signaux des lectures de colonnes et des lectures de lignes dans des échelles de résistances respectives, et dans lequel l'emplacement d'un événement détecté est récupéré en lisant les deux extrémités de chaque échelle de résistances.

10. Dispositif d'imagerie (1) selon l'une quelconque des revendications précédentes, dans lequel chaque pixel (8) des modules de détection pixellisés (5) comprend un scintillateur configuré pour convertir des électrons incidents en impulsions lumineuses, le scintillateur étant monté sur une photodiode à avalanche.

11. Dispositif d'imagerie (1) selon l'une quelconque des revendications précédentes, dans lequel chaque pixel (8) des modules de détection pixellisés (5) a une longueur de côté x telle que :

$$1mm \leq x \leq 6mm.$$

12. Dispositif d'imagerie (1) selon l'une quelconque des revendications précédentes, dans lequel les moyens (6) pour déplacer mutuellement la pluralité de modules de détection (5) comprennent un actionneur configuré pour déplacer les modules de détection de manière coopérative les uns par rapport aux autres, par exemple selon un mouvement linéaire ou non linéaire.

13. Dispositif d'imagerie (1) selon l'une quelconque des revendications précédentes, comprenant en outre :

une source (21) des électrons ;
des moyens (22) pour focaliser les électrons en un faisceau pour irradier l'échantillon à inspecter ;
des moyens (23) pour balayer le faisceau sur l'échantillon ;
une unité d'analyse spectrale (24) située sous l'unité de détection (3), et
une chambre à vide (25) renfermant la source, les moyens de focalisation et de balayage, l'échantillon lorsqu'il est présent, l'unité de détection, les moyens (6) pour déplacer mutuellement la pluralité de modules de détection (5) de l'unité de détection, et l'unité d'analyse spectrale.

14. Procédé (100) de fonctionnement d'un dispositif d'imagerie (1) pour un microscope électronique à transmission et à balayage, le dispositif d'imagerie comprenant une unité de détection (3) comprenant une pluralité de modules de détection pixellisés (5), l'unité de détection étant configurée pour recevoir des électrons après qu'ils ont été transmis à travers un échantillon à inspecter, le procédé comprenant le déplacement mutuel de la pluralité de modules de détection pour commander une surface d'un trou (7) dans l'unité de détection.

15. Procédé (100) selon la revendication 14, comprenant en outre :

la détermination de la position de la pluralité de modules de détection pixellisés (5) après leur déplacement mutuel ; et
l'ajustement d'un flux de données de sortie de l'unité de détection (3), sur la base de la position déterminée.

Fig. 1B

Fig. 1A

Fig. 2A

Fig. 2B

Fig. 2C

Fig. 3A

Fig. 3B

Fig. 4A

Fig. 4B

Fig. 4C

Fig. 5

Fig. 6

Fig. 7

Fig. 9

Fig. 8

100

Fig. 10

**EP 4 546 394 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 3534391 A1
- EP 3637452 A1
- EP 3965137 A1
- EP 12696363 A
- US 2008315094 A1